# EUROPEAN PATENT SPECIFICATION

(11) **EP 3 114 913 B1**
(45) Date of publication and mention of the grant of the patent: **17.06.2020**
(21) Application number: 15706253.0
(22) Date of filing: 26.02.2015
(51) Int. Cl.: H05K 7/14

(54) **ENCLOSURE FOR POWER ELECTRONIC COMPONENTS**
GEHÄUSE FÜR LEISTUNGSELEKTRONISCHE BAUELEMENTE
BOÎTIER POUR COMPOSANTS ÉLECTRONIQUES DE PUISSANCE

(30) Priority: 05.03.2014 EP 14157958
(43) Date of publication of application: 11.01.2017
(73) Proprietor: ABB Schweiz AG, 5400 Baden (CH)
(72) Inventor: GRADINGER, Thomas, 5032 Rohr (CH); DONZEL, Lise, 5430 Wettingen (CH); COTTET, Didier, 8050 Zürich (CH); GREUTER, Felix, 5406 Baden-Rütihof (CH)
(74) Representative: Kransell & Wennborg KB
(86) International application number: PCT/EP2015/054044
(87) International publication number: WO 2015/132128

(56) References cited:
- EP-A1- 1 975 949
- EP-A1- 2 701 476
- EP-A1- 2 701 477
- US-A- 6 163 457

## Description

### Technical Field

The present invention relates to the insulation of electric and electronic components in an enclosure. In particular, the invention relates to a modular electric and/or electronic system with power electronic components located in an enclosure, with an improved field grading.

### Background Art

In electric equipment, in particular in medium-voltage (MV) frequency converters or drives, it is attractive to go to higher voltages, since, for the same power, less current is needed. This reduces the system losses, the conductor cross-sections and the amount of copper necessary. The increase in application voltage is particularly facilitated by new converter topologies like the modular multilevel converter (MMC). In these topologies, in each phase leg, many so-called cells are electrically connected in series.

Going to higher voltages is, generally, a challenge in terms of electric insulation. While air insulation is cheap and technologically simple, the necessary clearance distances strongly increase with the voltage. This makes it very demanding to build compact converters in the higher MV range. It is therefore, in principle, attractive to use solid insulation. Because of the much higher electric strength of solid insulation compared to air, the insulation distance can be significantly reduced, and hence the converter power density can be increased.

In MMCs, several cells are usually combined to a converter module. The converter modules are arranged in a cabinet in matrix form, i.e. in columns and rows, like drawers in a shelf. As the individual cells are on different potential, neighboring cells must be insulated from each other. In case of solid insulation, this is achieved by the module enclosure, which basically looks like a box, housing the electronic components of the cells. The module enclosure mostly is open on the front and back, such that cooling air can flow through.

Power electronics building blocks are used in a wide field of applications, for example in frequency conversion. Thereby, particularly in the medium to high voltage range, it is a demanding task to integrate the involved semiconductor based circuitry in an economic space, and to simultaneously fulfill the requirements with respect to heat dissipation, i.e. cooling, and safety against both the risk of electric shocks and the problem of partial discharges.

Some attempts have been made to insulate such cells of modules by solid materials, e.g. by using dielectric housings. An example for such a concept can be found in Steiner M., Reinold, H.: "Medium Frequency Topology in Railway Applications", European Railway Review (EPE), 2007, Aalborg, Denmark. However, none of these approaches has as of yet led to an application in marketable converter module products, partly due to persisting problems with partial discharges.

Further, known from US 6,163,457 is a module of a circuit arrangement which is contained in a drive for a railroad vehicle and is of modular construction. In the module according to this document, at least one first power-electronic assembly which is at high voltage as well as electrical connections (which are connected to this assembly) of a transformer which couples a second power-electronics assembly forming a DC insulation point are arranged in a dielectric material housing. The housing is normally designed in a cuboid shape, and the dielectric material housing in each case has an electrically conductive layer, which is connected to frame or ground potential, on its top surface and bottom surface as well as on its front face which is closed at the front. An electrical connection of the first power-electronics assembly is passed through each of the two side surfaces of the dielectric material housing. The arrangement of this document thus makes use of a capacitive control of an arising electrical field.

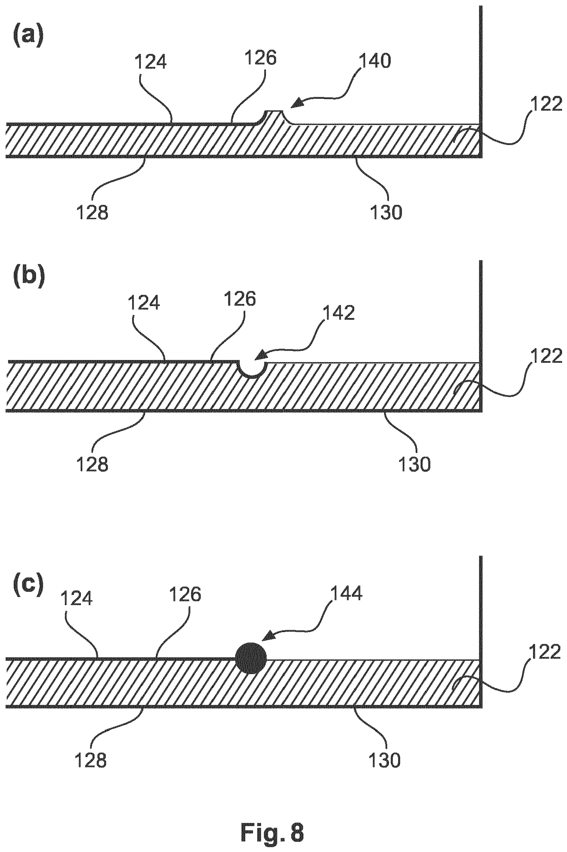

Figure 8 shows capacitive field grading according to the prior art. It may be seen that an enclosure wall 122 of an enclosure for electronic elements comprises a conductive layer 124 at the inner face 126 and a conductive layer 128 at an outer face 130 of the enclosure wall 122. According to the prior art, capacitive field grading is performed by providing a rounded surface of the enclosure wall 122 in the form of a web 140, see Fig. 8a, or in the form of a groove 142, see Fig. 8b. According to Fig. 8c, the end of the conductive layer 124 is arranged as a circle or ball 144. These grading methods, however, provide complex construction processes.

In view of the above, there are still possibilities to improve the field control of modular arrangements as described in the known solutions.

EP 2701477 A1 discloses an enclosure for an electronic device comprising an enclosure wall of a dielectric material, a first conductive layer abutting an inner face (50) of the enclosure wall, and a second conductive layer abutting an outer face of the enclosure wall, wherein the first and the second conductive layers are electrically insulated from each other by the enclosure wall and are electrically connectable to predefined electric potentials by a connection means, so that the electric field in the enclosure wall can be homogenized in an operational state of the enclosure.

### Disclosure of Invention

It is an object of the present invention to provide an enclosure for power electronic components, in particular for power converter modules, which provides an improved field grading.

This object is at least partly solved by an enclosure according to claim 1 like will be apparent below. Advantageous embodiments are described in the dependent claims.

In particular, the present invention provides an enclosure for power electronic components. The enclosure according to the invention comprises: an enclosure wall comprising an insulating material, a first conductive layer covering a portion of an inner face of the enclosure wall, and a second conductive layer covering at least a portion of an outer face of the enclosure wall, wherein the first and the second conductive layers are electrically insulated from each other by the enclosure wall and are capable of exhibiting a different electrical potential, and wherein at least a portion of the inner face of the enclosure wall not being covered with a conductive layer and abutting the portion being covered with the conductive layer is covered by a resistive material layer.

Such an enclosure provides improved insulation properties of the power electronic components, in particular of power converter cells, especially with regard to medium voltage and high voltage. It further allows permitting or at least reducing the appearance of field peaks and thus allows improved field grading properties.

Generally, embodiments of the invention pertain to modular electronic systems having a plurality of power electronic cells being arranged in an enclosure and forming together with the enclosure power electronic modules.

Several enclosures may be arranged in an array, for example an m-by-n matrix. The enclosures may be arranged such that they can be fitted or mounted to each other via mounting elements on the outer faces of the enclosures. In embodiments, the enclosures may be pullably mounted in a rack or cabinet, so that the electrical contacts (operating voltage, ground, etc.) are typically provided on the rear side of the modules. The terms cabinet and rack are used interchangeably herein, wherein they are not necessarily closed bodies; they may also be shelf-shaped elements for inserting electronic modules. The term "medium voltage" mentioned above is understood as a rated voltage of about 1000 Volts up to about 36000 Volts (DC, or rms voltage in case of AC). A voltage higher than this is regarded hereinafter as "high voltage". One has to be aware that the equipment should be able to withstand impulse voltages (e.g. a lightning impulse) that are typically much higher (e.g. above 100 kV) even for MV equipment. See e.g. IEC 61800-5-1, Tab. 8 for reference.

In particular, the invention relates to an enclosure of a power converter module. A power converter module particularly comprises the enclosure together with one or more power converter cells. In case of a modular-multilevel-converter (MMC), for example, these cells are particularly physically implemented by submodules. Physically, the power converter cell contains typically each one or more of a power semiconductor module, capacitor, cooler, bus bar, gate drive, control electronic, communication device, auxiliary power supply.

The enclosure is provided for placing the power converter cells. The enclosure may thus be formed as a cabinet having a plurality of receiving rooms, or receiving sections, each of which being designed for receiving one or more of the respective cells. As the individual cells are on different potential, an electric insulation is required. The respective receiving rooms are thus electrically insulated against each other by the enclosure.

In order to achieve this insulation, the enclosure comprises an enclosure wall which forms the respective receiving rooms and thus defines the main part of the enclosure. The enclosure wall is formed from an insulating material which is adapted for electrically insulating the respective cells from each other.

Further, a first conductive layer covering a portion of an inner face of the enclosure wall, and a second conductive layer covering at least a portion of an outer face of the enclosure wall are provided. The respective conductive layers being located at the inner face, and thus the face being directed towards the receiving room of the cells, and at the outer face are electrically insulated from each other by the enclosure wall and are capable of exhibiting a different electrical potential.

The conductive coatings may avoid field peaks to occur especially in case parts of the cells located inside the enclosure are in contact with or near the enclosure or the conductive layer. However, due to the fact that the conductive layers have different electrical potentials, at least the inner coating has to end at some distance from the enclosure end especially in axial direction (front-back direction) of the enclosure. As a potentially present front cover such as an electrically conductive grille for preventing human access to parts under electrical potential is preferably on ground potential, a clearance and creepage distance between a coating end and cover or enclosure front end is required. On the back, there may be no grille, but also here a clearance and creepage distance is advantageous between the ends of the coating. According to this, generally the danger of an electrical field to occur may exist at the coating ends which may result in damaging the insulation, for example.

In embodiments, the conductive layer also called field shaping conductive layer covers at least 30 to 40 % of the overall inner face of the enclosure wall, and/or at least 30 to 40 % of the overall outer face of the enclosure wall. The field grading conductive layer may be applied in form of a coating that is applied to the enclosure wall after forming the same.

The enclosure wall comprises an insulating material and has dielectric properties, which are sufficient for allowing the respective cells to be electrically insulated from each other. For example, the dimensions as well as the material of the enclosure wall may be dielectrically designed to permanently withstand an rms operating voltage of 24 kV between either sides of the enclosure wall. In detail, the dimensions as well as the material of the enclosure wall may be dielectrically designed to permanently withstand an rms operating voltage of 24 kV between the first conductive layer and the second conductive layer.

The provision of the first and second conductive layers like described above may have significant advantages. In fact, the insulation distances in the solid material, or enclosure wall, respectively, can be kept particularly low, if the enclosure wall is conductively coated on one or especially on both sides. The conductive coating serves to homogenize the field and avoid or reduce field peaks. This is generally known in the art and the material and the conductivity of the conductive material may be adapted to the specific application. For example, the conductive layer may comprise a metal.

As non-limiting examples, the conductive layers comprise a material selected from the group consisting of copper, aluminium, silver, gold, iron, an alloy of any of the afore-named materials or a mixture of any of the afore-named materials or a highly conductive paint based on any of the afore -named materials. For example, at least one of the conductive layers may consist of one or more of the afore-named materials or of an alloy of any or more of the afore-named materials or of a mixture of any or more of the afore-named materials. It could be found that especially the afore-named materials, alloys or mixtures may provide an especially effective field shaping effect and are furthermore very stable.

Components may touch the enclosure wall, as one tries to arrange the enclosure as densely as possible. Without such coatings, components under potential, touching the enclosure, cause electric field peaks in the enclosure that often lead to dielectric aging and breakdown. Also, components as for example heat sinks often have sharp edges that may lead to the appearance of strong field peaks leading to the above described disadvantages.

The conductive coatings provided on the inner surface as well as on the outer surface of the enclosure wall are, however, particularly not provided over the whole outer and especially inner surface of the enclosure wall. This is due to the fact that the inner and the outer conductive coatings mostly are on different electrical potentials. For example, the inner coating may have an electric potential which corresponds to a part, such as the cell or a part thereof, touching the inner coating, whereas the outer coating lies on ground potential. Therefore, it has to be avoided that the inner coating and the outer coating come close to each other.

In order to avoid this, especially the inner surface of the enclosure wall is not fully covered by the conductive coating but a certain distance is held between one or more edges of the enclosure wall and the conductive coating. Further, it may be provided that the outer surface of the enclosure wall is as well only partially coated by the conductive layer. At the layer ends, however, electric field peaks may occur which has to be avoided.

According to the invention, the portion or at least a part thereof not being provided with a conductive coating and thus especially the surface of the clearance distances is thereby covered with a resistive material layer. In other words, at least a portion of the inner face of the enclosure and optionally additionally a portion of the outer face of the enclosure not being covered with a conductive layer and abutting the portion of the inner or outer face, or surface, of the enclosure wall being covered with the respective conductive layer is covered by a resistive material layer.

By using a resistive material layer like described above, a resistive field grading may be achieved which field grading is very effective and may prevent disadvantages like described above. In other words, resistive rather than capacitive field grading is used to avoid field peaks at the edge of the conductive coating.

Further, the structures of the prior art which are used for field grading may block part of the cooling-air flow going through the enclosure. This disadvantage is significantly reduced by the present invention.

A disadvantage of the solutions of the prior art may further be seen in the fact that the insulation thickness may be reduced at the base of a groove, for example, compared to the wall thickness in the rest of the enclosure. The enclosure shall thus be dielectrically dimensioned for the minimum thickness. In contrast, using resistive field grading, the thickness of the enclosure wall may be constant.

The provision of a resistive material layer on the surface of the enclosure wall, for example as a coating, may thereby be realized very cost-efficiently. This becomes especially clear when thinking about solutions being provided according to the prior art. In detail, it is known to provide capacitive field grading. This may be achieved by rounding the coating end, like shown in figure 8. To this end, the enclosure must have a rounded surface, either in the form of a web, or in the form of a groove. The electrode-end cross-section may further be extended to a circle, which is most effective in reducing field peaks. However, such solutions are only producible in a complex manner.

The resistive material layer may be arranged abutting the conductive layer. According to this the respective ends of the resistive material layer and the conductive layer are located directly one next to the other and touching each other. This arrangement may be provided especially cost-saving and may already provide an improved field-grading effect.

Alternatively, an overlap of the resistive material layer and the conductive layer may be provided such, that the resistive material layer is at least partly located above or beneath the conductive layer. According to this embodiment, an especially large contact area of the conductive layer and the resistive material layer may be reached allowing a good conductive connection. It has been found that especially according to this embodiment a very effective field grading may be reached together with a very effective dynamic response behaviour. The overlap used may be chosen in dependence of the specific application. As a non-limiting example, an overlap of ≥ 2mm to ≤20mm, for example approximately 5mm may be appropriate. The degree of overlap may further be chosen in dependence of the specific arrangement. It may further be chosen, which end of the resistive material layer and the conductive layer lies above the respective other end. It may thus be appropriate that the end of the resistive layer material lies above the conductive coating, or vice versa.

According to a further embodiment the resistive material layer is provided at least partly between the conductive layer and the enclosure wall. It could thus be advantageous to first apply the field-grading layer, or resistive material layer, partly or on the complete inner or outer surface, before applying the conductive layer. According to this embodiment, the resistive material layer may for example act as a kind of adhesive for applying the conductive layer. This may be especially advantageous in case the resistive material comprises a matrix for receiving a filler component. In this case, the properties of the matrix may be adapted to provide good adhesive properties. This allows an especially easy and cost-saving manufacturing process and further provides a very stable arrangement.

According to a further embodiment, the resistive material layer is in contact to an electrically conductive grille being provided in an opening of the enclosure and thus at least partly closing said opening. In case an electrically conductive grille is present for example for cooling purposes, this embodiment is especially preferred for DC applications, but may also be used for AC applications.

The same holds for an embodiment according to which the resistive material layer is in contact with the first conductive layer and the second conductive layer. This may be realized, for example, in case the conductive material encompasses the enclosure wall on a respective side.

According to a further embodiment, the resistive material layer comprises a non-linear resistive material. A non-linear resistive material according to the present invention is thereby particularly a material which has an electric conductivity σ(E) being dependent on the electric field and that increases from a comparably lower conductivity value, σ(low), to a comparably higher conductivity value a(high), especially in a narrow field region ΔE around a value E_{b}. In other words, a non-linear resistive material changes its electrical conductivity from a value which corresponds to a comparably low electrical conductivity, at which conditions the non-linear resistive material is an electrical insulator, to a value which corresponds to a comparably high electrical conductivity, at which conditions the non-linear resistive material is electrically conductive. The change of the conductivity is thereby triggered by an electrical field acting on the non-linear resistive material. At a low electrical field, the non-linear resistive material is an electrical insulator. In case the electrical field rises above a so-called switching field, E_{b}, the non-linear resistive materials become strongly conductive.

Non-limiting examples for non-linear resistive materials comprise coated mica pigments, such as those which are purchasable under the name Minatec from the company Merck and/or which are coated with antimon-doped tin oxide, coated glass, coated ceramic, carbon black, graphene, graphene oxide, optionally doped silicium carbide (SiC) and microvaristors, such as based on zinc oxide (ZnO) pure or doped, e.g.with Bi₂O₃ and Sb₂O₃, or tin oxide (SnO₂) such as pure or doped, such as with antimony.

Such non-linear resistive materials may be present as such, or as a filling material in a matrix of appropriate material, such as in a matrix of a polymer, such as thermoplastic, elastomeric, duroplastic polymers, gel or grease.

It is however especially preferred that the non-linear resistive material comprises microvaristors, or in other words microvaristor particles. For example, the microvaristor particles are based on, or comprise, zinc oxide (ZnO) or tin oxide (SnO₂). According to this embodiment, an especially effective field grading effect may be reached together with low losses in the non-linear resistive material. Non-linear field-grading materials, based on ZnO or SnO₂ microvaristor particles have a low electric conductivity at low electric fields. At electric fields above a so-called switching field E_{b}, they become strongly conductive.

The particles of the microvaristors may be mixed in an electrically insulating matrix, such as polymers like thermoplasts, duroplasts, elastomers, gels, greases, glass, silicones, ceramics and others. The microvaristors may be present in an amount of ≥ 10 vol.-% to ≤ 60 vol.-%, particularly in an amount of ≥ 25 vol.-% to ≤ 45 vol.-%, for example in an amount of 35 vol.-%, regarding the overall mixture with the matrix.

Further, microvaristors have the advantage that their electric properties such as switching field E_{b} are tunable to the desired application in a very broad manner. An adaption may thereby be realized by adapting the manufacturing process, especially the sintering process and by choosing the kind of dopants, like it is known in the art.

Apart from that, microvaristors have very sharp switching transitions and a high nonlinearity extending over many decades in current density, allowing efficient resistive limitation of the electric field at impulse. They have a high resistivity up to a high operational field strength and hence have low power losses in normal operation.

The microvaristor particles comprise particularly particles having a size in the range of ≤ 100 µm, particularly ≤ 60 µm. The respective particles are generally available from known companies.

According to a further embodiment, the resistive material layer is provided as a multi-layer structure. According to this embodiment, the resistive material layer may be provided not only as one single layer, but two or more layers of the resistive material may be provided. The plurality of layers may be located at least partly over each other, or these layers may incorporate the conductive layer and may thus form a kind of sandwich structure. The plurality of layers may also comprise an insulating protective layer covering the resistive layer. This embodiment may be advantageous especially in critical areas, such as in contact regions where a building block contacts the enclosure, or it may be provided at the whole dimension of the resistive material layer. According to this embodiment, an especially effective field grading effect may be reached, thereby allowing a good adaption to the desired application and the occurring electrical field.

Further, with regard to the manufacturing process of the enclosure or the enclosure walls, the following processes may be especially advantageous: injection molding, pulltrusion, extrusion, winding, taping or casting.

With regard to injection molding or casting, for example, even though a comparably high initial tooling investment may be required for generating a special tool, once a specific tool is made this procedure is fast and economic for very high numbers of pieces.

Referring to pulltrusion, the initial tooling investment is rather low. Hence, this manufacturing technology is suited also for low to medium numbers of pieces and is therefore especially adaptable. Naturally, only profiles may advantageously be produced. While this limits the enclosure geometry which however is acceptable for most applications, the following is also an advantage: the pultruded profile can be cut to any length; i.e. with one pulltrusion tool, enclosures of different lengths can be produced. This enables a scalable design of the power electronic components. For example, the number of capacitors per cell can be varied according to the application needs. The cell volume needed to accommodate the capacitors is then provided by varying the length of the pultruded enclosure which again shows the high degree of adaptability.

Using the enclosure-manufacturing technologies like described above, these processes are especially well adapted to the provision of a resistive field grading material as in this case non-complex geometries may be used. In contrast thereto, the enclosure geometry needed for capacitive field grading (see Fig. 8) and as such containing either a groove or a protrusion on the inside of the enclosure cannot be pultruded. It can also not be casted or injection molded in an easy manner, since the cores of the mold cannot be easily removed from the form. Further, grooves need to be machined in case of a pultruded enclosure. This means an extra, costly manufacturing step, which is particularly demanding since the grooves are deep inside the enclosure, and hence not easily accessible to the mill. Furthermore the grooves have to be metallized without leaving any small voids, in order not to generate local discharges at these regions of enhanced field. Therefore, the manufacturing processes described above are applicable to the solutions according to the prior art in a limited manner only, but are well applicable to the solution according to the invention.

In case of injection molding, again, a limitation to distinct shapes does not apply or only in a very limited manner. Still, these geometries according to the prior art can possibly not be made easily, since one must be able to retrieve the cores of the mold after molding. The geometries are all reentrant, hence the core cannot directly be pulled out. A solution could be a complex multi-core tool, which is unwanted because of high cost and reduced life time.

To summarize, the processes stated are especially advantageous with regard to the solution according to the invention and allow a significant improvement with regard to cost-efficiency and to providing highly adaptable processing methods.

According to a further embodiment, at least one of the conductive layer and the resistive material layer is applied by spraying, such as thermal spraying, painting, printing, winding, taping, physical vapor deposition, chemical vapor deposition, galvanic deposition, gluing of a substrate, such as of a foil, of a sheet, of a mesh or of a fabric, overmolding, or dip coating. Surprisingly, it has been found that especially by using the above-named processes, the advantages of the conductive layer and particularly of the resistive material layer may be especially effective.

According to a further embodiment, the enclosure wall comprises at least one of a polymer, a fibre or particle reinforced plastic or polymer, and a ceramic. As an example, the enclosure wall may be formed from an epoxy resin filled with quartz powder. Especially the afore-named materials as insulating materials may provide good dielectric properties already when using comparably small wall thicknesses, so that the enclosure may be formed especially compact and with a reduced weight, which may be advantageous especially with regard to mobile applications.

The present invention further refers to a power converter, comprising an enclosure like described above. With regard to the technical features and advantages of the power converter, such as a modular multilevel converter, according to the invention it is referred to the above description of the enclosure.

### Brief Description of Drawings

These and other aspects of the invention will be apparent from and elucidated with reference to the embodiments described hereinafter.

In the drawings:
- Fig. 1: shows a typical topology of a modular multilevel converter (MMC) as an example for a power converter;
- Fig. 2: shows a detailed view of the topology of figure 1;
- Fig. 3: shows an exemplary front view of a power converter comprising a plurality of power converter modules;
- Fig. 4: shows the sectional side view along the axis B-B of the arrangement of figure 3;
- Fig. 5: shows a sectional front view of an embodiment of an enclosure including two branches comprising cells of a power converter module;
- Fig. 6: shows a more detailed sectional side view of the embodiment of figure 4; and
- Fig. 7: shows a sectional side view of a part of the enclosure with a field grading layer.
- Fig. 8: shows measures for capacitive field grading according to the prior art.

### Detailed Description of the Invention

Reference will now be made in detail to various embodiments, one or more examples of which are illustrated in each figure. Each example is provided by way of explanation and is not meant as a limitation. For example, features illustrated or described as part of one embodiment can be used on or in conjunction with other embodiments to yield yet further embodiments. It is intended that the present disclosure includes such modifications and variations.

Within the following description of the drawings, the same reference numbers refer to the same components. Generally, only the differences with respect to the individual embodiments are described. When several identical items or parts appear in a figure, not all of the parts have reference numerals in order to simplify the appearance.

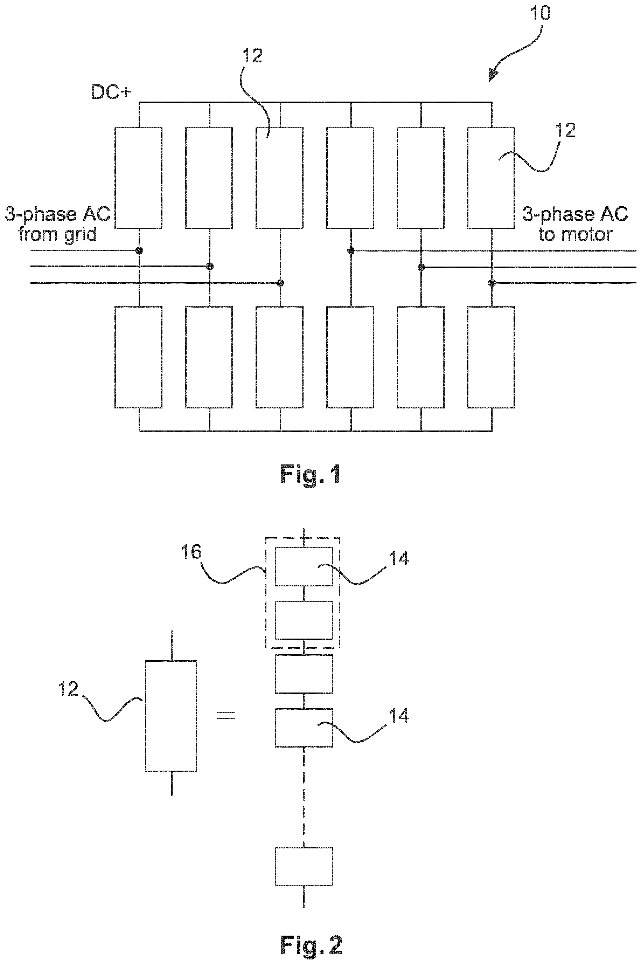

Figures 1 and 2 show the typical topology of a modular multilevel converter (MMC) as an example of a power converter 10 optionally being positioned between a grid and a motor wherein figure 1 shows a three-phase AC arrangement. The modular power converter 10 comprises a plurality of branches 12 each of which is formed from a plurality of cells 14 connected electrically in series. One or more cells 14, housed in an enclosure 20, form, together with enclosure 20, a power converter module 16.

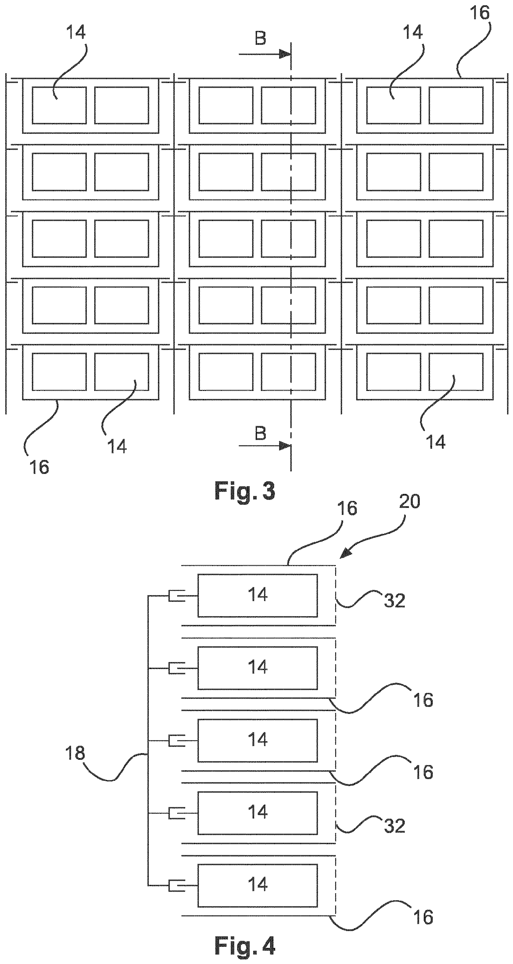

Figures 2 and 3 show, as an example, converter modules 16 comprising two cells 14. Characteristically, the cells 14 grouped in one converter module 16 are neighbours in the branch 12 and have therefore similar voltage. Therefore, the voltage between cells 14 in a converter module 16 is small compared to the voltage between different converter modules 16, and also small compared to the voltage cell-to-ground or converter-module-to-ground.

The electrical insulation of cells 14 that are close to the DC bus (DC+ or DC-, see Figure 1) is thereby predominantly exposed to DC stress during operation. However, cells 14 closer to the phase connections (either on the grid or on the motor side) are more exposed to AC voltage. This is an additional challenge for the field-grading system, if it should work for all positions within the MMC stack (in particular for all cells along an MMC branch) and this challenge may be solved according to the invention. For DC stress the resistive field grading layer must connect both the conductive shaping layer and the grille or the two shaping layers with each other.

Figure 3 shows the arrangement of a plurality of power converter modules 16 with its cells 14 as part of the modular multilevel converter, or the power converter 10, respectively. It can be seen that the modules 16 are arranged in a cabinet in matrix form, i.e. in columns and rows, like drawers in a shelf. Figure 4 shows the sectional side view indicated in figure 3. Here, it can be seen that the respective converter modules 16 are connected via a bus bar 18 at their rear side.

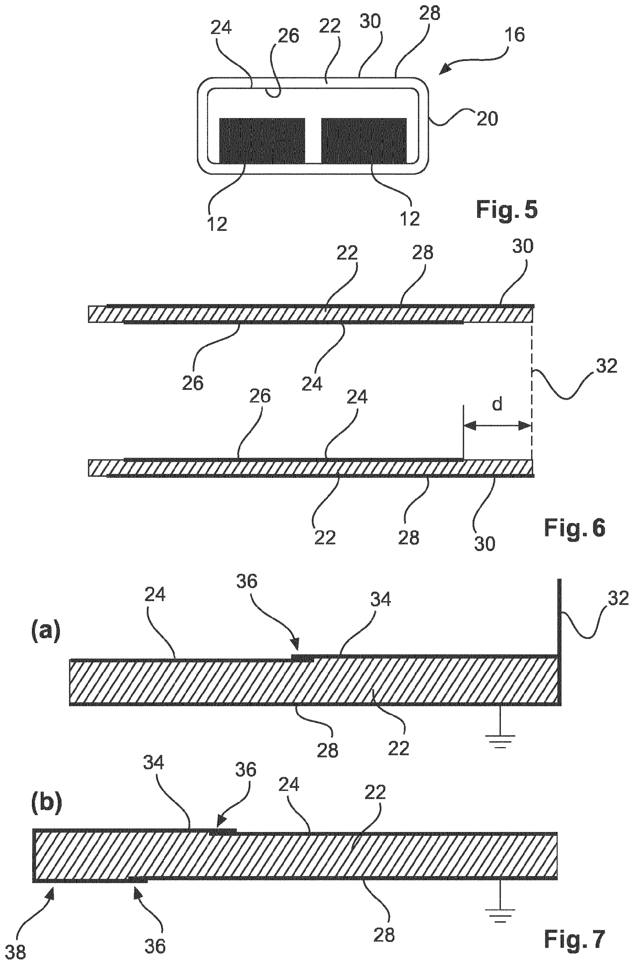

Figures 5 and 6 show an enlarged and more detailed view of an enclosure 20, such as in a cuboid form, for a power converter module 16. It can be seen that the enclosure 20 comprises an enclosure wall 22 comprising a dielectric material, a first conductive layer 24 covering a portion of an inner face 26 of the enclosure wall 22, and a second conductive layer 28 covering at least a portion of an outer face 30 of the enclosure wall 22. The conductive layers 24, 28 may be fixed to the enclosure wall 22 by a conductive glue or another suitable glue, for example. It may be provided that at least one of the conductive layers 24, 28 comprises a material selected from the group consisting of copper, aluminium, silver, gold, iron, an alloy of any of the afore-named materials or a mixture of any the afore-named materials and/or that the enclosure wall 22 comprises at least one of a polymer, a fibre polymer and a ceramic.

Therefore, the first 24 and the second 28 conductive layers are electrically insulated from each other by the enclosure wall 22 and are capable of exhibiting a different electrical potential. Further and with regard to figure 6 it can be seen that the enclosure 20 is open on e.g. for electrical contacts and for cooling purposes at its rear end end and has a grille 32 on the front end in order to allow a stream of cooling gas, such as air, flowing through the enclosure 20. In other words, the enclosure 20 may have a front opening for cooling purposes and a rear opening for electric connections and for cooling purposes.

In embodiments, which can be combined with other embodiments described herein, the openings in the front and back of the enclose 20 may be provided with a grille 32 or grid structure to protect from touching according to high voltage insulation standards. The grille should be electrically connected to ground potential.

Due to the fact that the first conductive layer 24, or inner coating, mostly is not on ground potential, a distance d between the end of the conductive layer 24 and the enclosure end should be foreseen, like it is shown in figure 6. Due to the fact that at the end of such layer 24 field peaks may occur, a further coating is applied that may extend from the end of the first conductive layer 24 to the structure such as the grille 32 which is on ground. This further coating is resistive and acts as a field-grading material. In detail, a portion of the inner face 26 of the enclosure wall 22 and optionally a portion of the outer face 30 of the enclosure wall 20 not being covered with a conductive layer 24, 28 and abutting the conductive layer 24, 28 is covered by a particularly non-linear resistive material layer 34 and as such by the afore-mentioned coating comprising said non-linear resistive material. This significantly reduces or completely prevents the occurrence of such field peaks.

The non-linear resistive material may particularly comprises microvaristor particles comprising ZnO or SnO₂ or other types of microvaristors, preferably comprising particles having a size in the range ≤ 100 µm. Possible further field-grading materials, or non-linear resistive materials, could comprise coated platelets or fillers such as Minatec conductive pigments, or carbon black or graphene or graphene oxide or silicium carbide and mixtures thereof. The resistive material may also be coating, e.g.a diamond like carbon coating.

The resistive material layer 34 may connect the conductive layer 24 and the grille 32, for example, see figure 7a). This contact is mandatory for cases with DC loads. Further, at the rear end 38 of the enclosure 20 which is open, and thus at the end being opposite to the grille 32, the field-grading material, or the resistive material layer 34 may extend around the edge of the enclosure wall 22, such that both conductive layers 24, 26 are contacted, see figure 7b). Again this is mandatory for DC loads.

Preferably, an overlap 36 of the non-linear resistive material layer 34 and the conductive layer is provided for good contacting.

While the invention has been illustrated and described in detail in the drawings and foregoing description, such illustration and description are to be considered illustrative or exemplary and not restrictive; the invention is not limited to the disclosed embodiments. Other variations to be disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or" an" does not exclude a plurality. The mere fact that certain measures are recited in mutually different dependent claims does not indicate that a combination of these measures cannot be used to advantage. Any reference signs in the claims should not be construed as limiting scope.

### Reference signs list

- 10: power converter
- 12: branch
- 14: cell
- 16: power converter module
- 18: busbar
- 20: enclosure
- 22: enclosure wall
- 24: first conductive layer
- 26: inner face
- 28: second conductive layer
- 30: outer face
- 32: grille
- 34: resistive material layer
- 36: overlap
- 38: rear end
- 122: enclosure wall
- 124: conductive layer
- 126: inner face
- 128: conductive layer
- 130: outer face
- 140: web
- 142: groove
- 144: ball

## Claims

1. Enclosure for power electronic components, comprising:
an enclosure wall (22) comprising an insulating material,
a first conductive layer (24) covering a portion of an inner face (26) of the enclosure wall (22), and
a second conductive layer (28) covering at least a portion of an outer face (30) of the enclosure wall (22), wherein
the first (24) and the second (28) conductive layers are electrically insulated from each other by the enclosure wall (22), **characterized in that,**
the first (24) and the second (28) conductive layers are capable of exhibiting a different electrical potential, and wherein
at least a portion of the inner face (26) of the enclosure wall (22)
not being covered with a conductive layer (24) and abutting the portion being covered by the conductive layer (24) is covered by a resistive material layer (34).

2. Enclosure according to claim 1, wherein the resistive material layer (34) is arranged abutting the conductive layer (24).

3. Enclosure according to claim 1, wherein an overlap (36) of the resistive material layer (34) and the conductive layer (24, 28) is provided such, that the resistive material layer (34) is at least partly located above or beneath the conductive layer (24).

4. Enclosure according to any of the preceding claims, wherein the resistive material layer (34) is provided at least partly between the conductive layer (24, 28) and the enclosure wall (22).

5. Enclosure according to any of the preceding claims, wherein the resistive material layer (34) is in contact to an electrically conductive grille (32) provided in an opening of the enclosure (20).

6. Enclosure according to any of the preceding claims, wherein the resistive material layer (34) is in contact with the first conductive layer (24) and the second conductive layer (28).

7. Enclosure according to any of the preceding claims, wherein the resistive material layer (34) comprises a non-linear resistive material.

8. Enclosure according to claim 7, wherein the non-linear resistive material comprises at least one of coated mica, coated glass, coated ceramic, carbon black, graphene, graphene oxide, silicon carbide, a microvaristor or a mixture of one or more of the afore-named components.

9. Enclosure according to any of the preceding claims, wherein the resistive material layer (34) is provided as a multi-layer structure.

10. Enclosure according to any of the preceding claims, wherein at least one of the conductive layer (24, 28) and the resistive material layer (34) is applied by spraying, painting, winding, taping, printing, physical vapor deposition, chemical vapor deposition, galvanic deposition, gluing of a substrate, overmolding, or dip coating.

11. Enclosure according to any of the preceding claims, wherein the enclosure wall (22) comprises at least one of a polymer, a fibre or particle reinforced polymer and a ceramic.

12. Power converter, comprising an enclosure (20) according to any of the preceding claims.

## Patentansprüche

1. Gehäuse für Leistungselektronikkomponenten, umfassend:
eine Gehäusewand (22), die ein isolierendes Material umfasst,
eine erste leitfähige Schicht (24), die einen Abschnitt der Innenseite (26) der Gehäusewand (22) bedeckt, und
eine zweite leitfähige Schicht (28), die mindestens einen Teil der Außenseite (30) der Gehäusewand (22) bedeckt, wobei
die erste (24) und die zweite (28) leitfähige Schicht durch die Gehäusewand (22) elektrisch voneinander isoliert sind, **dadurch gekennzeichnet, dass**
die erste (24) und die zweite (28) leitfähige Schicht in der Lage sind, ein unterschiedliches elektrisches Potential zu besitzen, und wobei
mindestens ein Abschnitt der Innenseite (26) der Gehäusewand (22), der nicht mit einer leitfähigen Schicht (24) bedeckt wird und an den Abschnitt angrenzt, der von der leitfähigen Schicht (24) bedeckt wird, von einer resistiven Materialschicht (34) bedeckt wird.

2. Gehäuse nach Anspruch 1, wobei die resistive Materialschicht (34) so angeordnet ist, dass sie an die leitfähige Schicht (24) angrenzt.

3. Gehäuse nach Anspruch 1, wobei ein Überschneiden (36) der resistiven Materialschicht (34) und der leitfähigen Schicht (24, 28) so bereitgestellt wird, dass die resistive Materialschicht (34) mindestens teilweise über oder unter der leitfähigen Schicht (24) angebracht wird.

4. Gehäuse nach einem der vorhergehenden Ansprüche, wobei die resistive Materialschicht (34) mindestens teilweise zwischen der leitfähigen Schicht (24, 28) und der Gehäusewand (22) bereitgestellt wird.

5. Gehäuse nach einem der vorhergehenden Ansprüche, wobei die resistive Materialschicht (34) in einem Kontakt mit einem elektrisch leitfähigen Gitter (32) steht, das in einer Öffnung des Gehäuses (20) bereitgestellt wird.

6. Gehäuse nach einem der vorhergehenden Ansprüche, wobei die resistive Materialschicht (34) in einem Kontakt mit der ersten leitfähigen Schicht (24) und der zweiten leitfähigen Schicht (28) steht.

7. Gehäuse nach einem der vorhergehenden Ansprüche, wobei die resistive Materialschicht (34) ein nicht lineares resistives Material umfasst.

8. Gehäuse nach Anspruch 7, wobei das nichtlineare resistive Material mindestens eines umfasst von einem beschichtetem Mika, einem beschichteten Glas, einem beschichteten Keramikmaterial, Ruß, Graphen, Graphenoxid, Siliciumcarbid, einem Mikrovaristor oder einer Mischung aus einem oder mehreren der zuvor genannten Komponenten.

9. Gehäuse nach einem der vorhergehenden Ansprüche, wobei die resistive Materialschicht (34) als eine Mehrschichtstruktur bereitgestellt wird.

10. Gehäuse nach einem der vorhergehenden Ansprüche, wobei mindestens eine der leitfähigen Schicht (24, 28) und der resistiven Materialschicht (34) durch Sprühen, Malen, Wickeln, Aufbringen eines Klebebands, Drucken, eine physikalische Gasphasenabscheidung, eine chemische Gasphasenabscheidung, eine galvanische Abscheidung, Aufkleben eines Substrats, Umspritzen oder Tauchlackieren appliziert wird.

11. Gehäuse nach einem der vorhergehenden Ansprüche, wobei die Gehäusewand (22) mindestens Eines von einem Polymer, einem faser- oder partikelverstärkten Polymer und einem Keramikmaterial umfasst.

12. Stromrichter der ein Gehäuse (20) nach einem der vorhergehenden Ansprüche umfasst.

## Revendications

1. Enceinte pour composants électroniques de puissance, comprenant :
une paroi d'enceinte (22) comprenant un matériau isolant,
une première couche conductrice (24) recouvrant une partie d'une face interne (26) de la paroi d'enceinte (22), et
une deuxième couche conductrice (28) recouvrant au moins une partie d'une face externe (30) de la paroi d'enceinte (22), dans laquelle
les première (24) et deuxième (28) couches conductrices sont électriquement isolées l'une de l'autre par la paroi d'enceinte (22), **caractérisée en ce que**
les première (24) et deuxième (28) couches conductrices peuvent présenter un potentiel électrique différent, et dans laquelle
au moins une partie de la face interne (26) de la paroi d'enceinte (22) non recouverte par une couche conductrice (24) et contiguë à la partie recouverte par la couche conductrice (24) est recouverte par une couche de matériau résistif (34).

2. Enceinte selon la revendication 1, dans laquelle la couche de matériau résistif (34) est disposée de façon contiguë à la couche conductrice (24).

3. Enceinte selon la revendication 1, dans laquelle un chevauchement (36) de la couche de matériau résistif (34) et de la couche conductrice (24, 28) est prévu, de telle sorte que la couche de matériau résistif (34) est au moins partiellement située au-dessus ou au-dessous de la couche conductrice (24).

4. Enceinte selon l'une quelconque des revendications précédentes, dans laquelle la couche de matériau résistif (34) est disposée au moins partiellement entre la couche conductrice (24, 28) et la paroi d'enceinte (22).

5. Enceinte selon l'une quelconque des revendications précédentes, dans laquelle la couche de matériau résistif (34) est en contact avec une porte électriquement conductrice (32) disposée dans une ouverture de l'enceinte (20).

6. Enceinte selon l'une quelconque des revendications précédentes, dans laquelle la couche de matériau résistif (34) est en contact avec la première couche conductrice (24) et la deuxième couche conductrice (28).

7. Enceinte selon l'une quelconque des revendications précédentes, dans laquelle la couche de matériau résistif (34) un matériau résistif non linéaire.

8. Enceinte selon la revendication 7, dans laquelle le matériau résistif non linéaire comprend au moins un composant parmi le mica revêtu, le verre revêtu, la céramique revêtue, le noir de carbone, le graphène, l'oxyde de graphène, le carbure de silicium, une microvaristance, ou un mélange d'un ou plusieurs des composants susmentionnés.

9. Enceinte selon l'une quelconque des revendications précédentes, dans laquelle la couche de matériau résistif (34) est disposée comme une structure multicouche.

10. Enceinte selon l'une quelconque des revendications précédentes, dans laquelle au moins une couche parmi la couche conductrice (24, 28) et la couche de matériau résistif (34) est appliquée par pulvérisation, peinture, enroulement, rubanage, impression, dépôt physique en phase vapeur, dépôt chimique en phase vapeur, dépôt galvanique, collage d'un substrat, surmoulage, ou revêtement au trempé.

11. Enceinte selon l'une quelconque des revendications précédentes, dans laquelle la paroi d'enceinte (22) comprend au moins un élément parmi un polymère, un polymère renforcé de fibres ou de particules et une céramique.

12. Convertisseur de puissance, comprenant une enceinte (20) selon l'une quelconque des revendications précédentes.
